# EUROPÄISCHE PATENTSCHRIFT

(11) **EP 2 902 277 B1**
(45) Veröffentlichungstag und Bekanntmachung des Hinweises auf die Patenterteilung: **06.04.2016**
(21) Anmeldenummer: 14199328.7
(22) Anmeldetag: 19.12.2014
(51) Int. Cl.: B60R 25/20, H03K 17/955, E05F 15/46, E05F 15/73

(54) **Auswerteverfahren für einen kapazitiven Annäherungssensor an einem Kraftfahrzeug**
Evaluation method for a capacitive proximity sensor on a motor vehicle
Procédé d'évaluation pour un capteur de proximité capacitif sur un véhicule automobile

(30) Priorität: 23.01.2014 DE 102014100746
(43) Veröffentlichungstag der Anmeldung: 05.08.2015
(73) Patentinhaber: Huf Hülsbeck & Fürst GmbH & Co. KG, 42551 Velbert (DE)
(72) Erfinder: Schindler, Mirko, 42549 Velbert (DE); Van Gastel, Peter, 42699 Solingen (DE)
(74) Vertreter: Zenz Patentanwälte Partnerschaft mbB

(56) Entgegenhaltungen:
- EP-B1- 2 384 294
- WO-A1-02/089042
- DE-A1-102005 035 935
- DE-A1-102010 037 509
- DE-A1-102011 051 434
- US-A1- 2009 027 068

## Beschreibung

Die Erfindung betrifft ein Auswerteverfahren zur Verwendung mit kapazitiven Annäherungssensoren an einem Kraftfahrzeug. Insbesondere betrifft die Erfindung ein Verfahren zur energieoptimierten Ansteuerung von kapazitiven Sensorelektroden an Fahrzeugen.

Die Erfassung von Annäherungen an Kraftfahrzeugen mit kapazitiven Sensoren sind im Stand der Technik bekannt. Zum Beispiel werden kapazitive Annäherungssensoren als Bestandteile von sogenannten Keyless-Entry-Systemen eingesetzt. Die kapazitiven Elektroden werden dazu beispielsweise in der Handhabe eines Türgriffs für Fahrzeuge eingesetzt.

Derartige kapazitive Türgriffanordnungen sind z. B. aus der DE 10 2005 035 935 A1 bekannt. Des Weiteren sind kapazitive Annäherungssensoren auch bei der berührungslosen Betätigung von Heckklappen im Einsatz, wie z. B. in der EP 2 384 294 B1 beschrieben.

Die Funktionsweise von kapazitiven Annäherungssensoren ist dementsprechend in der Technik bekannt, es gibt in diesem Zusammenhang am Markt verfügbare Ansteuerungs- und Auswerteschaltungen für die Kopplung mit Sensorelektroden. Das Erfassungsprinzip basiert darauf, dass eine Sensorelektrode hinsichtlich der Kapazität und der Veränderung der Kapazität der Elektrode gegenüber der Umgebung ausgewertet wird. Dazu können beispielsweise zyklische Umladungen der Sensorelektrode durchgeführt werden, wobei bei einer vorgegebenen Spannung auf der Sensorelektrode eine kapazitätsabhängige Ladung akkumuliert und diese anschließend auf eine Messkapazität umgeladen wird. Über mehrere Messzyklen können dann Ladungsmengen auf der Messkapazität gesammelt werden und nach einer vorgegebenen Anzahl von Messzyklen wird die dort vorhandene Ladung ausgewertet, um Rückschlüsse auf die Kapazität der Sensorelektrode ziehen zu können. Die Kapazität der Sensorelektrode verändert sich in Abhängigkeit von der Annäherung eines Benutzers oder Bedieners an die Elektrode, beispielsweise wenn eine Hand oder ein Fuß in die Nähe der Sensorelektrode bewegt wird. Anhand der Kapazität kann entsprechend die Annäherung des Benutzers detektiert werden.

Ein Problem bei den bekannten Einrichtungen ist der Energiebedarf der entsprechenden Ansteuerungs- und Auswerteschaltungen, da die Einrichtungen oftmals in einem sensiblen Modus gehalten werden, selbst wenn gar keine Annäherung zu erfassen ist. Auf diese Weise soll sichergestellt werden, dass bei Annäherung eines Benutzers rasch und verzögerungsfrei die erwünschte Funktion zur Verfügung steht.

Die DE 10 2011 051 434 A1 offenbart eine kapazitive Sensoranordnung, die zum optimierten Energieeinsatz beitragen soll. Dabei wird eine kapazitive Sensoranordnung mit mehreren Sensoren so angesteuert, dass nur eine der Sensoranordnungen mit hoher Frequenz abgefragt wird während die anderen nur dann in einem hochfrequenten Erfassungsmodus geschaltet werden, wenn die erste Elektrode eine mögliche Annäherung anzeigt. Auf diese Weise werden die mit geringer Frequenz angesteuerten kapazitiven Sensorelektroden in eine Art Bereitschaftsmodus versetzt, bis die hochgetaktete Elektrode eine Annäherung anzeigt.

Aufgabe der Erfindung ist es, den ID-Bedarf von Auswerteverfahren und der Sensoranordnung weiter zu verbessern.

Diese Aufgabe wird durch ein Verfahren mit den Merkmalen des Patentanspruchs 1 gelöst.

Gemäß dem erfindungsgemäßen Verfahren wird eine Sensoranordnung in einem energiereduzierten Modus betrieben. In diesem energiereduzierten Modus wird die Sensoranordnung beispielsweise mit geringerer Frequenz abgefragt als in einem energieintensiveren Modus, der beispielsweise mit höherer Abfragefrequenz durchgeführt wird.

Der energieintensivere Modus wird im Folgenden als Präzisionsmodus bezeichnet, während der energiereduzierte Modus als Bereitschaftsmodus bezeichnet wird.

Die Erfindung ist dabei nicht dahingehend eingeschränkt, in welcher Weise sich Präzisionsmodus und Bereitschaftsmodus unterscheiden. Wesentlichen ist, dass der Energiebedarf im Präzisionsmodus höher ist und die Messdatenerfassung energieintensiver, dafür jedoch genauer ist. Für die verlässliche Auswertung der Sensordaten, beispielsweise der Auswertung, ob eine Bediengeste vorliegt, sind die Daten aus dem energieintensiveren Modus erforderlich. Die Daten aus dem Bereitschaftsmodus erlauben keine verlässliche Auswertung derartiger Signale, sie werden im Rahmen der Erfindung dazu verwendet, die Umschaltung in den Präzisionsmodus auszulösen.

Gemäß der Erfindung wird also eine Sensoreinrichtung im Bereitschaftsmodus mit geringerer Frequenz oder geringerer Spannung oder sonst wie energieoptimiert angesteuert und die Auswertung wechselt nur bei einem auslösenden Ereignis (Trigger-Ereignis), welches aus den Daten der Sensoranordnung abgeleitet wird, in dem Präzisionsmodus.

Im Präzisionsmodus wird dann die Sensordatenerfassung mit höherem Energieanspruch, beispielsweise gesteigertem Stromverbrauch jedoch in verbesserter Genauigkeit, Auflösung oder Sensitivität durchgeführt.

Nähert sich also beispielsweise ein Benutzer an eine Sensorelektrode eines Fahrzeuges an, zeigt die energiereduzierte Sensordatenerfassung lediglich, dass ein mögliches Benutzerereignis bevorsteht, da sich die Kapazitätsdaten der Sensoranordnung signifikant verändern, beispielsweise einen Schwellwert überschreiten oder unterschreiten. Tritt ein solcher Trigger-Ereignis auf wird in das sensiblere, genauere Betriebsschema gewechselt und eine tatsächlich ausgeführte Bediengeste, beispielsweise eine Handbewegung, die Annäherung einer Hand an den Türgriff oder die Schwenkbewegung eines Fußes können mit erhöhter Genauigkeit verfolgt werden.

Erfindungsgemäß ist jedoch vorgesehen, die Daten im hochsensitiven Präzisionsmodus um weitere Daten zu ergänzen. Es kann nämlich durchaus sein, dass ein Bedienereignis bei Auslösung des Triggers und Umschaltung des Verfahrens bereits im Gange ist und sogar teilweise stattgefunden hat. Zur Energieoptimierung sind jedoch die Sensordaten im Zeitraum vor dem Trigger-Ereignis, also aus dem Bereitschaftsmodus für die Auswertung nicht verwertbar, beispielsweise da sie gar nicht abgespeichert wurden, sondern lediglich auf Vorliegen des Trigger-Ereignisses überprüft werden. Außerdem sind sie mit anderen Parametern aufgenommen als die Daten des sensitiveren Präzisionsmodus. Eine Mischung der Daten aus beiden Betriebsmodi bei der Auswertung einer Messdatenfolge geht zu Lasten der Genauigkeit der Auswertung. Gemäß der Erfindung wird aus den Daten die ab der Umschaltung in den Präzisionsmodus erfasst werden auf Daten aus dem Zeitraum vor dem Trigger-Ereignis zurückgerechnet. Es werden also beispielsweise die Daten ab dem Umschaltzeitpunkt im Präzisionsmodus mit hoher Sensitivität oder hoher Frequenz oder hoher Auswertegenauigkeit erfasst und anhand dieser Daten, beispielsweise einer Anzahl von Daten, die unmittelbar nach dem Trigger-Ereignis im Präzisionsmodus erfasst wurden, werden Daten aus dem Zeitraum vor der Umschaltung generiert.

Diese Generierung von Messdaten kann dabei anhand einer abgespeicherten Tabelle oder auch einer mathematischen Formel erfolgen, welche einen erwarteten Messdatenverlauf für ein Bedienereignis wiedergeben. Je nach Anordnung und Ausgestaltung der Sensorelektrode und Art der Bedienung wird ein gültiger Signalverlauf bei der Erkennung von Bedienungen vorausgesetzt, wobei dieser Signalverlauf eine gewisse Toleranz aufweist. Beispielsweise wird bei einer Schwenkbewegung des Fusses unter dem Heck eines Fahrzeuges ein Signalanstieg auf ein Maximum, eine Umkehrung und ein Abfall erwartet. Diese erwartete Signalfolge wird bei der Generierung oder Rückrechnung berücksichtigt. Der Toleranz wird dabei durch die Anpassung an die tatsächlich erfassten Präzisionsdaten Rechnung getragen. Wenn sich der erwartete Signalverlauf durch eine geeignete mathematische Funktion (z.B. lineare Funktion plus einer Glockenkurve) beschreiben lässt, kann ein Fit der Funktion an die Präzisionsdaten erfolgen.

Die generierten Daten sind also keine tatsächlich gemessenen oder über die Sensoranordnung erfassten Daten, sondern Daten, die derartige gemessene Daten für einen Zeitraum simulieren, in dem sich die Einrichtung noch im weniger sensiblen Modus befand. Entsprechend können di generierten Daten auch gemäß den Parametern des Präzisionsmodus generiert werden, sie werden also beispielsweise für eine simulierte Erfassungsfrequenz generiert, die in energiesparendem Modus gar nicht vorlag.

Dieses erfindungsgemäße Vorgehen hat mehrere Vorteile. Einerseits kann die Erfassungsgenauigkeit im Bereitschaftsmodus und damit der Energiebedarf sehr weit reduziert werden, da die dort erfassten Messdaten ausschließlich für die Auslösung des sensitiveren Modus herangezogen werden. Da die Messdaten aus diesem Zeitraum vor dem Trigger-Ereignis nicht in die tatsächliche spätere Auswertung eingehen sind die Anforderungen an die erfassten Daten aus diesem Zeitraum äußerst gering und damit kann eine besonders gute Energiereduzierung herbeigeführt werden.

Ein weiterer Vorteil besteht darin, dass ein Einfluss von unterschiedlichen Ansteuerungsverfahren oder Auswerteverfahren auf die Messanordnung ausgeschlossen wird. Wird also die kapazitive Sensoreinrichtung mit geringerer Frequenz im Bereitschaftsmodus angesteuert, sind die dort erfassten Kapazitätsdaten nicht unter denselben Voraussetzung erfasst, wie die Messdaten im Präzisionsmodus weil die Apparatur sich aus diesem Zustand und der Ansteuerung heraus anders verhält als im Präzisionsmodus, sei es durch Umladungseffekte, parasitäre Ströme, Aufwärmungseffekte etc.

Schließlich ist das Konzept weitgehend unabhängig von dem Umschaltzeitpunkt vom Bereitschaftsmodus in den Präzisionsmodus. Je nach Bedingungen und Art der Annäherung des Bediener kann es durchaus sein, dass die Umschaltung sehr zu Beginn der Annäherung stattfindet, so dass nahezu die gesamte Bedienung mit ihrer Dynamik im Präzisionsmodus erfasst wird. Dann liegen tatsächliche Messdaten für nahezu den gesamten Bedienzeitraum vor. Erfolgt hingegen die Umschaltung erst zu einem weiter fortgeschrittenen Zeitpunkt der Bedienung, liegen für den Anfangszeitraum keine tatsächlichen Präzisionsdaten vor. Eine Bedienung weist aber insbesondere im Mittelbereich der Bedienung (z.B. bei Ausführung einer Bediengeste um den Wendepunkt der Geste) die größte Dynamik auf. Dies wird durch die Erfindung implizit berücksichtigt, da die Rückrechnung auf Basis der anfänglichen Zeitfolge von Präzisionsdaten erfolgt. Hat die Umschaltung früh stattgefunden, so ist die Dynamik der ersten Präzisionsdaten gering und entsprechend auch die Dynamik der rückgerechneten Daten. Ist hingegen die Dynamik der ersten Daten groß, z.B. eine starke Steigung vorhanden, so wirkt sich dies aufgrund des Rückgriffs auf ein erwartetes Dynamikverhalten auch auf die rückgerechneten Daten aus. Diese Berücksichtigung der Dynamik anhand der Präzisionsdaten ist verlässlicher als der Rückgriff auf Daten aus dem Bereitschaftsmodus.

Das Konzept der Erfindung generiert demnach Messdaten aus einem Zeitraum vor dem Trigger-Ereignis und der Umschaltung in den Präzisionsmodus vollständig durch eine interne Rückrechnung oder einen Zugriff auf gespeicherte exemplarische Daten, also beispielsweise Datenschablonen. Diese Daten, die aus dem Daten nach dem Trigger-Ereignis auf einen Zeitraum vor dem Trigger-Ereignis zurückgerechnet wurden, gehen dann zusammen mit den tatsächlich erfassten Daten (Präzisionsdaten) nach dem Trigger-Ereignis in die Messdatenauswertung ein. Die Daten werden also zusammen mit den real erfassten Daten der weiteren Auswertung, beispielsweis Mustererkennung im Datenverlauf zugeführt.

Die Rückrechnung der Daten aus den tatsächlichen Präzisionsdaten im weiteren Verlauf hat den Vorteil, dass die nachfolgende Auswertung einheitlich und unabhängig vom Zeitpunkt des Umschaltens erfolgen kann. Die Auswertung kann immer auf Basis einheitlicher Daten erfolgen, unabhängig davon ob ein Teil davon rückgerechnet wurde. Diese nachfolgende Auswertung kann daher auf die Auswertung von Präzisionsdaten spezialisiert werden. Es hat sich gezeigt, dass dieses Verfahren hinsichtlich der Erfassung und Auswertung sehr unterscheidungsgenaue Auswertungen erlaubt.

In einem bevorzugten Ausführungsform der Erfindung wird anhand einer vorgegebenen Anzahl von Messdaten, die nach dem Trigger-Ereignis im Präzisionsmodus erfasst wurden eine zweite vorgegebene Anzahl von Messdaten auf dem Zeitraum vor dem Trigger-Ereignis zurückberechnet. Diese Rückberechnung erfolgt beispielsweise anhand einer gespeicherten Polynomialentwicklung mit an die erfassten Daten angepassten Koeffizienten, welche einen Signalanstieg oder Signalabfall, der für eine Bediengeste charakteristisch ist, in diesem Signalabschnitt beschreiben. Alternativ wird auf eine gespeicherte Tabelle von Werten zurückgegriffen, welche gemäß den erfassten Messdaten mit Lichtungsfaktoren versehen werden. Schließlich kann auch ein beliebiges anderes Fitting-Verfahren einer bekannten Art (z.B. least square) angewandt werden, um andere mathematische Funktionen oder Kurvenverläufe an die real erfassten Werte anzupassen und die Daten zeitlich zurückentwickeln.

Es ist besonders bevorzug, wenn die Rückrechnung anhand von Präzisionsdaten aus einem Zeitraum erfolgt, der bei Vorliegen bestimmter Kriterien der Daten endet. Beispielsweise werden die zeitlichen Präzisionsdaten gespeichert und wenn festgestellt wird, dass die Signale einen Extremwert überschritten haben (Maximum oder Minimum) wird die Rückrechnung anhand aller bis dahin gespeicherten Präzisionsdaten ausgeführt. Die Zahl der Präzisionsdaten für die Rückrechnung ist dann nicht fest vorgegeben sondern Abhängig vom Eintritt des Kriteriums.

In einer bevorzugten Ausführungsform unterscheiden sich der Bereitschaftsmodus und der Präzisionsmodus in der Frequenz der Abfrage der Sensorelektroden. Beispielsweise werden die Daten der Sensorelektrode im Präzisionsmodus mit der dreifachen bis hundertfachen Frequenz abgefragt wie im Bereitschaftsmodus. Jede Abfrage kann dabei eine mehrfache Umladung der Sensorelektroden über Umladezyklen aufweist.

In einer anderen Ausführungsform werden zusätzlich oder alternativ die Anzahl der Auswertezyklen jeder Messung zwischen Präzisionsmodus und Bereitschaftsmodus variiert. Während also beispielsweise im Bereitschaftsmodus für die Erfassung eines Kapazitätswertes der Sensorelektrode eine Umladung der Sensorelektrode über eine erste Anzahl von Zyklen erfolgt, werden für den sensibleren Präzisionsmodus mehr Umladezyklen verwendet, beispielsweise um einen Faktor 2 bis 10 mehr.

Wesentlich ist, dass die Sensoranordnung in wenigstens zwei unterschiedlichen Weisen anzusteuern ist, wobei die eine deutlich gegenüber der anderen energiereduziert arbeitet. Die Ansteuerung und Auswertung im energiereduzierten Modus dient ausschließlich der Erkennung eines Triggers für die Umschaltung in den energieintensiveren Modus, während die dort erfassten Messdaten nicht für eine Bedienerkennung zur Verfügung stehen und ausgewertet werden. Ausschließlich die Messdaten im energieintensiveren Präzisionsmodus, die mit höherer Frequenz oder Sensitivität oder Genauigkeit zur Verfügung stehen, dienen der Auswertung des tatsächlichen Bedienereignisses. Auf Basis dieser Daten werden jedoch Messdaten für einen Zeitraum zurückgerechnet, in dem die Einrichtung eigentlich gar nicht im sensitiven, hochenergieintensiven Modus arbeitet.

Die Rückschaltung in den energiearmen Modus kann beispielsweise nach einem vorgegebenen Zeitablauf erfolgen, nach erfolgreicher Erkennung einer Benutzergeste oder in Abhängigkeit von den ausgewerteten Messdaten.

Die Erfindung wird nun anhand der beiliegenden Figuren näher erläutert.
Figur 1 zeigt in schematischer Weise die Anordnung einer Sensorelektrodenanordnung zur Ausführung des erfindungsgemäßen Verfahrens;
Figuren 2a bis 2c zeigen in schematischer Weise die Messwerterfassung anhand eines beispielhaften Erfassungsvorgangs.

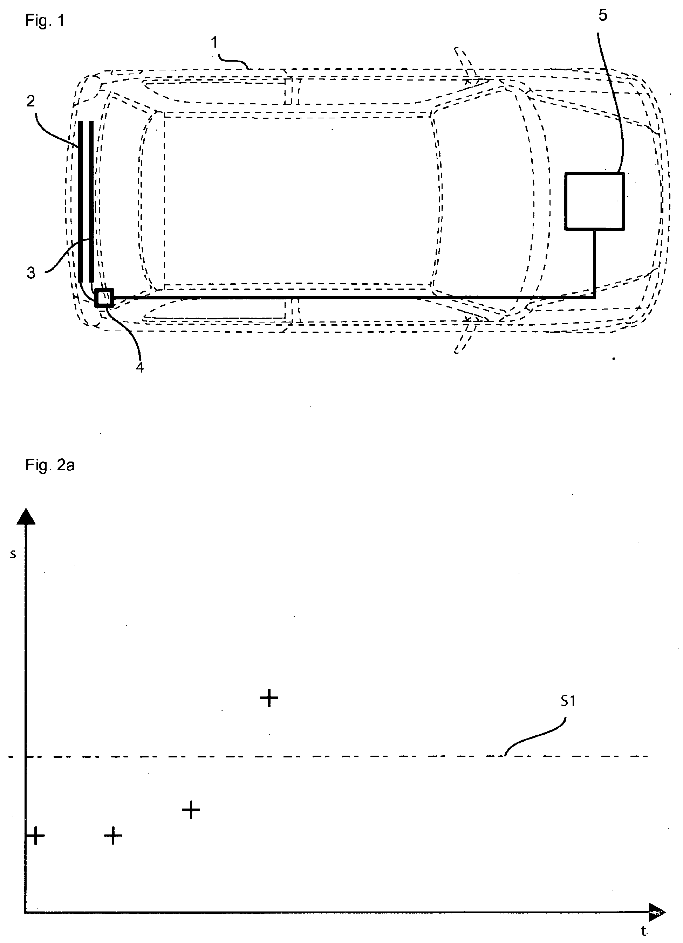

In Figur 1 ist ein Fahrzeug 1 gezeigt, in dessen Heckbereich zwei Sensorelektroden 2 und 3 angeordnet sind. Die Sensorelektroden 2, 3 sind als langgestreckte Elektroden entlang der Fahrzeugbreite angeordnet. Ein Benutzer kann durch Annäherung an diese Elektroden und mittels einer Gestikausführung mit einem Fuß die Betätigung der Heckklappe vornehmen. Zur Ansteuerung und Auswertung sind die Elektroden 2, 3 mit einer Steuer- und Auswerteeinrichtung 4 gekoppelt. In dieser Steuer- und Auswerteeinrichtung 4 ist ein Mikrokontroller mit zugehörigen Schaltungskomponenten angeordnet, der zur Ausführung des erfindungsgemäßen Verfahrens programmiert ist. Die Steuer- und Auswerteeinrichtung 4 ist wiederum mit einer zentralen Steuereinrichtung 5 des Fahrzeuges gekoppelt, um erkannte Betätigungen an die zentrale Einrichtung 5 zu übermitteln, damit von dort die Öffnung der Heckklappe ausgelöst wird. Ziel der Erfindung ist es, die Steuer- und Auswerteeinrichtung 4 mit samt den Sensorelektroden 2, 3 in den Zeiten, in den keine Erfassung stattfindet, in einem energieoptimierten Modus zu versetzen, wobei dennoch bei Benutzerzugriff sofort eine komfortable und verlässliche Auswertung der Betätigung möglich ist.

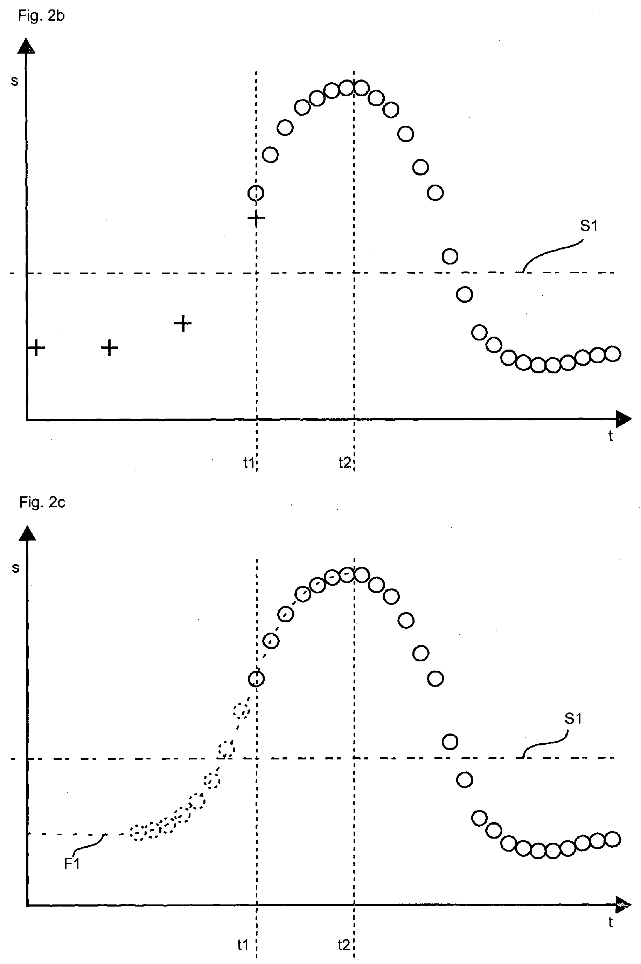

Die Figuren 2a, 2b und 2c zeigen in schematischer Weise das erfindungsgemäße Auswerteverfahren. In Figur 2a ist entlang einer Zeitskala t dargestellt, wie die Steuer- und Auswerteinrichtung 4 bei einer der Elektroden 2, 3 eine Signalerfassung in energiereduzierten Bereitschaftsmodus ausführt. Die Messpunkte im Bereitschaftsmodus sind durch Kreuze im Koordinatensystem dargestellt. Die Messfrequenz ist reduziert, die Kapazität einer der Elektroden wird also beispielsweise mit einer geringen Frequenz von 5Hz vorgenommen. Jeder der erfassten Messwerte wird mit dem Schwellwert S1 verglichen. Die ersten drei Messwerte liegen unterhalb des Schwellwertes, so dass der Bereitschaftsmodus beibehalten wird. Die Messwerte werden nach dem Vergleich mit dem Schwellwert ohne weitere Speicherung verworfen. Der vierte Messwert liegt oberhalb des Schwellwertes S1, was als Trigger-Signal für die Umschaltung innerhalb der Steuer- und Auswerteeinrichtung 4 auf einen Erfassungsmodus mit erhöhter Frequenz und Sensitivität gewertet wird.

Diese Umschaltung ist in Figur 2b vorgenommen. Die mit höherer Frequenz und Sensitivität aufgenommenen Messdaten liegen ab dem Zeitpunkt t1 der Umschaltung in dem Präzisionsmodus vor. Die tatsächlichen Messdaten sind als Präzisionsdaten hier als geschlossene Kreise gezeigt und werden mit deutlich höherer Frequenz erfasst als die Messdaten vor dem Zeitpunkt t1. Von dem Umschaltzeitpunkt an wird bis zum Zeitpunkt t2 eine Erfassung der Messdaten vorgenommen und aus diesem Messdatenverlauf werden für einen Zeitraum vor dem Zeitpunkt t1 rückwirkend zusätzliche Daten generiert.

Diese Rückrechnung ist in Figur 2c dargestellt. Eine in der Steuer- und Auswerteeinrichtung 4 gespeicherte Funktion Fl ist in gestrichelter Linie dargestellt. Mit einem Fit-Verfahren ist die Funktion an die Messdaten zwischen den Zeiten t1 und t2 angeglichen worden. Für dieses Beispiel ist die Kombination einer Linearfunktion mit einer Funktion einer Glockenkurve für die Anpassung verwendet worden. Für eine identische Frequenz, wie die tatsächliche Erfassung im Zeitraum zwischen t1 und t2 stattfindet, werden rückwirkend zusätzliche Stützstellen als zusätzliche Messdaten generiert. Diese generierten Daten liegen vor dem Zeitpunkt t1 und sind in der Darstellung in Figur 2c als gebrochene Kreise dargestellt. Diese Daten werden zusammen mit den tatsächlich erfassten Messdaten nach dem Zeitpunkt t1 der Auswertung zugeleitet. Die Auswertung findet also auf Basis der sämtlichen Messdaten zuzüglich der rückwirkend generierten Daten statt, so dass ein vollständiger Signalverlauf zum Musterverfahren vorliegt. Die Auswertung hat dabei keine Kenntnis, welche Daten tatsächlich erfasst wurden und welche rückgerechnet wurden und ist auf die Auswertung von Präzisionsdaten spezialisiert.

Es ist in Figur 2b beispielhaft dargestellt, dass zum Zeitpunkt t1 die Umschaltung von Bereitschaftsmodus in dem Präzisionsmodus mit erhöhter Erfassungsgenauigkeit und Frequenz erfolgt ist. In dieser schematischen Darstellung liegen zum Zeitpunkt t1 (entsprechend einer äußerst geringen Verzögerung in der Steuer- und Auswerteeinrichtung) sowohl ein Messwert gemäß der Auswertung im Bereitschaftsmodus, also ein Kreuz, als auch ein Messwert im sensitiveren Präzisionsmodus vor. Gemäß der Darstellung liegen diese Messwerte nicht exakt übereinander, was auf die unterschiedliche Ansteuerung der elektronischen Komponenten und der Elektrode bei den verschiedenen Betriebsmodi zurückzuführen ist. Beispielsweise wird für die Messungen im sensitiveren Modus eine höhere Anzahl von Messzyklen zu jedem Messpunkt vorgenommen, so dass mehr Testladungen der Elektrodenkapazität ausgewertet werden. Dies soll verdeutlichen, dass die Rückrechnung aus den tatsächlich erfolgten Daten, wie in Figur 2c dargestellt, ausschließlich auf die mit höherer Sensitivität und genauer erfassten Messdaten zurückgegriffen wird, ohne die Auswertung zu verfälschen.

Auf welche Weise die zeitlich rückgewandte Ermittlung zusätzlicher Messdaten erfolgt ist im Rahmen der Erfindung nicht eingeschränkt. Es können sowohl funktionale Zusammenhänge als auch tabellarische Werte verwendet werden. Wesentlich ist lediglich, dass die Rückermittlung auch nach Umschaltung in den energieintensiveren, jedoch genaueren und sensitiveren Modus erfolgt.

Es ist ebenfalls im Rahmen der Erfindung beliebig wählbar, wie die tatsächliche Auswertung des endgültig vorliegenden Werteverlaufs erfolgt. Im Rahmen der Sensorauswertungen und im Stand der Technik sind verschiedene Konzepte zur Unterscheidung von Betätigungsgesten und deren Messdaten und zufälligen Betätigungen bekannt. Beispielsweise ist es bekannt, die Messdaten mit Schwellwerten zu vergleichen und die Anstiegs- und Abklingdauer auszuwerten. Auch sind verschiedene Arte von Mustervergleichen möglich, wie im Stand der Technik zu entsprechenden Sensorauswerteverfahren dokumentiert ist.

## Patentansprüche

1. Verfahren zur Ansteuerung und Auswertung einer kapazitiven Sensoreinrichtung an Fahrzeugen (1), wobei die Sensoreinrichtung wenigstens eine Sensorelektrode (2, 3) aufweist, deren Kapazität zur Erkennung einer Umgebungsveränderung der Elektrode wiederholt abfragbar ist, wobei eine Steuer- und Auswerteeinrichtung (4) zur Ansteuerung der Sensorelektrode und zur Auswertung der Signale der Sensorelektrode ausgebildet ist,
aufweisend die Schritte,
Ansteuern und Abfragen der Sensorelektrode in einem Bereitschaftsmodus, wobei die Ansteuerung und Abfrage zur Minimierung des Energiebedarf angepässt ist,
Überwachen der Signale der Sensorelektrode im Bereitschaftsmodus, um das Auftreten eines Trigger-Ereignisses zu erkennen,
bei Vorliegen des Trigger-Ereignisses, Ansteuern und Abfragen der Sensorelektrode in einem Präzisionsmodus, wobei die Ansteuerung und Abfrage unter Erhöhung des Energiebedarfs zur Erhöhung der Signalqualität oder Signalauflösung erfolgt,
Erfassen einer Zeitfolge von Signaldaten im Präzisionsmodus,
Generieren von Ersatzdaten aus einer Menge der im Präzisionsmodus erfassten Daten, wobei diese Ersatzdaten als Zeitfolge von Signaldaten für einen Zeitbereich vor dem Trigger-Ereignis gespeichert werden,
Auswerten eines zeitlichen Signalverlaufs zur Erkennung eines Bedienereignisses, wobei die Auswertung auf wenigstens einer Menge der im Präzisionsmodus erfassten Daten und wenigstens einer Menge der Ersatzdaten basiert.

2. Verfahren nach Anspruch 1, wobei im Bereitschaftsmodus die Messwerte an der Sensorelektrode mit einer geringeren Frequenz erfasst werden als im Präzisionsmodus.

3. Verfahren nach Anspruch 1 oder 2, wobei für jede Erfassung eines Messwertes eine Folge von Umladungen der Sensorelektrode durch die Steuer- und Auswerteeinrichtung ausgeführt wird, wobei im Bereitschaftsmodus die Zahl der jeweils ausgeführten Umladungen gegenüber dem Präzisionsmodus reduziert ist.

4. Verfahren nach einem der vorangehenden Ansprüche, wobei als Trigger-Ereignis die Überschreitung eines vorgegebenen Schwellwertes durch einen im Bereitschaftsmodus erfassten Messwert oder die Unterschreitung eines vorgegebenen Schwellwertes durch einen im Bereitschaftsmodus erfassten Messwert gewertet wird.

5. Verfahren nach einem der vorangehenden Ansprüche, wobei im Bereitschaftsmodus jeder Messwert nach Prüfung auf das Trigger-Ereignis ohne Speicherung verworfen wird.

6. Verfahren nach einem der vorangehenden Ansprüche, wobei die Generierung von Ersatzdaten anhand einer vorgegebenen Anzahl von im Präzisionsmodus erfassten Daten erfolgt.

7. Verfahren nach einem der vorangehenden Ansprüche, wobei die Generierung von Ersatzdaten dann erfolgt, wenn die im Präzisionsmodus erfasste Zeitfolge von Messdaten ein vorgegebenes Kriterium erfüllt, insbesondere wenn die Zeitfolge von Messdaten einen Extremwert überschreitet oder einen Umkehrpunkt aufweist.

8. Verfahren nach einem der vorangehenden Ansprüche, wobei die Generierung von Messdaten anhand der Anpassung einer mathematischen Funktion an die ausgewählte Menge der Messdaten erfolgt, insbesondere durch Anpassung einer Polynomialfunktion oder einer Glockenkurve oder einer Kombination solcher Funktionen.

## Claims

1. Method for controlling and evaluating a capacitive sensor device on motor vehicles (1), wherein the sensor device comprises at least one sensor electrode (2, 3), the capacitance of which can be repeatedly sampled for detecting a change in the environment of the electrode, wherein a control and evaluation device (4) is implemented for controlling the sensor electrode and for evaluating the signals from the sensor electrode,
comprising the steps,
controlling and sampling the sensor electrode in a standby mode, wherein the control and sampling is adapted to minimize the energy required,
monitoring the signals of the sensor electrode in the standby mode in order to detect the occurrence of a trigger event,
when the trigger event is present, controlling and sampling the sensor electrode in a precision mode, wherein the control and sampling is performed with increased energy usage in order to increase the signal quality or signal resolution,
detecting a sequence of signal data in the precision mode,
generating substitution data from a set of the data detected in the precision mode, wherein these substitution data are stored as a sequence of signal data for a time period prior to the trigger event,
evaluating a temporal signal waveform to identify an operator event, wherein the evaluation is based on at least one set of the data detected in precision mode and at least one set of the substitution data.

2. Method according to Claim 1, wherein in the standby mode the measured values are detected at the sensor electrode with a lower frequency than in the precision mode.

3. Method according to Claim 1 or 2, wherein for each detection of a measured value, a series of recharges of the sensor electrodes is executed by the control and evaluation device, wherein in the standby mode the number of recharges executed is reduced compared to the precision mode.

4. Method according to any one of the previous claims, wherein a trigger event occurs when a measured value detected in standby mode exceeds a pre-defined threshold or a measured value detected in standby mode falls below a pre-defined threshold.

5. Method according to any one of the previous claims, wherein in standby mode every value measured after testing for the trigger event is discarded without saving.

6. Method according to any one of the previous claims, wherein the substitution data are generated using a pre-defined number of data items detected in precision mode.

7. Method according to any one of the previous claims, wherein the generation of substitution data occurs when the sequence of measured data detected in precision mode satisfies a pre-defined criterion, in particular when the sequence of measured data exceeds an extreme value or has a turning point.

8. The method according to any one of the previous claims, wherein the generation of measured data is effected by fitting a mathematical function to the selected set of measured data, in particular by fitting a polynomial function or a bell curve or a combination of such functions.

## Revendications

1. Procédé de commande et d'évaluation d'un dispositif de capteur capacitif sur des véhicules automobiles (1), dans lequel le dispositif de capteur présente au moins une électrode de capteur (2,3), dont la capacité peut être interrogée de manière répétée pour reconnaître une variation de l'environnement de l'électrode, dans lequel un dispositif de commande et d'évaluation (4) est conçu afin de commander l'électrode de capteur et d'évaluer les signaux de l'électrode de capteur, présentant les étapes consistant à,
commander et interroger l'électrode de capteur dans un mode de veille, dans lequel la commande et l'interrogation sont adaptées afin de minimiser la consommation d'énergie,
surveiller les signaux de l'électrode de capteur en mode de veille, afin de reconnaître l'apparition d'un événement déclencheur,
en présence de l'événement déclencheur, commander et interroger l'électrode de capteur dans un mode de précision, dans lequel la commande et l'interrogation ont lieu en augmentant la consommation énergétique afin d'augmenter la qualité de signal ou la résolution de signal,
détecter une séquence temporelle de données de signaux en mode de précision,
générer des données de remplacement à partir d'une quantité de données détectées en mode de précision, dans lequel ces données de remplacement sont mémorisées comme une séquence temporelle de données de signaux pour une plage temporelle précédant l'événement déclencheur,
évaluer une courbe de signal temporelle pour reconnaître un événement d'utilisateur, dans lequel l'évaluation se base sur au moins une quantité de données détectées en mode de précision et au moins une quantité de données de remplacement.

2. Procédé selon la revendication 1, dans lequel en mode de veille les valeurs de mesure sont détectées sur l'électrode de capteur avec une fréquence plus petite qu'en mode de précision.

3. Procédé selon la revendication 1 ou 2, dans lequel pour chaque détection d'une valeur de mesure une séquence de recharges d'une électrode de capteur par l'intermédiaire du dispositif de commande d'évaluation est effectuée, dans lequel en mode de veille le nombre de recharges déjà effectuées est réduit par rapport au mode de précision.

4. Procédé selon une des revendications précédentes, dans lequel comme événement déclencheur le dépassement d'une valeur seuil prescrite par une valeur de mesure détectée en mode de veille ou le sous dépassement d'une valeur seuil prescrite par une valeur de mesure détectée en mode de veille est prise en compte.

5. Procédé selon une des revendications précédentes, dans lequel en mode de veille chaque valeur de mesure après contrôle de l'événement déclencheur est rejetée sans mémorisation.

6. Procédé selon une des revendications précédentes, dans lequel la génération de données de remplacement a lieu sur la base d'un nombre prescrit de données détectées en mode de précision.

7. Procédé selon une des revendications précédentes, dans lequel la génération de données de remplacement a ensuite lieu quand la séquence temporelle de données de mesure détectées en mode de précision remplit un critère prédéterminé, notamment quand la séquence temporelle de données des mesure dépasse une valeur extrême ou un point de renvoi.

8. Procédé selon une des revendications précédentes, dans lequel la génération de données de mesure a lieu sur la base de l'adaptation d'une fonction mathématique à la quantité sélectionnée de valeurs de mesure, notamment en adaptant une fonction polynomiale ou une courbe de Gauss ou une combinaison de ces fonctions.
